# FASCICULE DE BREVET EUROPEEN

(11) **EP 3 084 132 B1**
(45) Date de publication et mention de la délivrance du brevet: **15.05.2019**
(21) Numéro de dépôt: 14828201.5
(22) Date de dépôt: 08.12.2014
(51) Int. Cl.: F01D 5/14, F01D 5/22, F01D 5/30

(54) **AUBE POUR ROUE À AUBES DE TURBOMACHINE ET PROCÉDÉ DE MODÉLISATION DE CELLE-CI**
SCHAUFEL FÜR EIN TURBOMASCHINENLAUFRAD UND VERFAHREN ZUR MODELLIERUNG DAVON
BLADE FOR A TURBO MACHINE IMPELLER AND METHOD FOR MODELLING THE SAME

(30) Priorité: 18.12.2013 FR 1362899
(43) Date de publication de la demande: 26.10.2016
(73) Titulaire: Safran Aircraft Engines, 75015 Paris (FR)
(72) Inventeur: BENICHOU, Sami, F-77550 Moissy-cramayel Cedex (FR); BARIAUD, Christian, F-77550 Moissy-cramayel Cedex (FR); DEFLANDRE, Stéphanie, F-77550 Moissy-cramayel Cedex (FR); DIGARD BROU DE CUISSART, Sébastien, F-77550 Moissy-cramayel Cedex (FR); HUCHIN, Patrick, Emilien, Paul, Emile, F-77550 Moissy-cramayel Cedex (FR)
(74) Mandataire: Duflos, Bertrand Guillaume
(86) Numéro de dépôt international: PCT/FR2014/053204
(87) Numéro de publication internationale: WO 2015/092204

(56) Documents cités:
- EP-A1- 1 734 227
- GB-A- 2 293 212
- US-A- 4 602 412

## Description

La présente invention concerne une aube pour roue à aubes de turbomachine ; l'aube comportant successivement, suivant une direction radiale de la roue, un pied, une pale, et un talon ; le pied comportant une plateforme de pied présentant une surface, dite veine de pied, du côté de la pale ; le talon comportant une plateforme de talon présentant une surface, dite veine de talon, du côté de la pale ; la pale comportant une surface externe dite surface de pale comportant un intrados et un extrados.

Le terme « veine » désigne donc ici la surface d'une plateforme de l'aube qui est du côté de la pale. La publication GB-2293212 décrit un exemple de veine.

Une telle aube peut être prévue pour faire partie d'une roue à aubes mobile, qui reçoit de l'énergie venant du flux de fluide qui la traverse, ou qui communique de l'énergie à ce flux ; elle peut également faire partie d'une roue à aubes fixe, dont le rôle est de canaliser le flux.

Une telle aube présentant à la fois une plateforme de talon et une plateforme de pied est une pièce de forme complexe. Sa fabrication est relativement difficile, et nécessite le plus souvent l'utilisation de moules ou d'outillages comportant des pièces multiples, et/ou éventuellement le recours à des centres d'usinage cinq axes.

L'objectif de l'invention est donc de remédier à ces inconvénients et de proposer des aubes dont la fabrication soit simplifiée ou facilitée par rapport aux aubes traditionnelles.

Cet objectif est atteint, dans une aube du type présenté en introduction, par le fait que chacune desdites veines est constituée par une partie d'intrados du côté de l'intrados et une partie d'extrados du côté de l'extrados, séparées par une courbe de crête allant d'un bord amont à un bord aval de la veine en traversant la pale, de telle sorte que chacune desdites veines présente une discontinuité de pente de part et d'autre de la courbe de crête ; et que tout point d'une première surface parmi l'intrados et l'extrados et tout point desdites parties des veines de pied et de talon situées du côté de la première surface, dites premières parties, présente une normale formant un angle aigu ou droit par rapport à une direction dite première direction de fabrication.

Le fait que la partie d'intrados soit du côté de l'intrados et la partie d'extrados soit du côté de l'extrados signifie que la partie d'intrados comprend au moins la partie de veine située en regard de l'intrados et la partie d'extrados comprend au moins la partie de veine située en regard de l'extrados.

La ligne de crête d'autre part s'étend en général sensiblement depuis le bord d'attaque de la pale, jusqu'à un point au bord amont de la plateforme qui est sensiblement au droit du bord d'attaque de la pale ; et de même, la ligne de crête s'étend en général sensiblement depuis le bord de fuite de la pale, jusqu'à un point au bord aval de la plateforme qui est sensiblement au droit du bord de fuite de la pale.

D'autre part, le fait qu'un point d'une surface présente une normale formant un angle aigu ou droit par rapport à une direction de fabrication signifie qu'en ce point, la surface ne présente pas de contre-dépouille vis-à-vis de la direction de fabrication considérée.

Par suite, la définition précédente implique que la première surface, et les parties de veines situées du côté de celles-ci (premières parties de veine) ne présentent aucune contre-dépouille vis-à-vis de la première direction de fabrication.

Grâce à cela, toute la partie de l'aube qui est délimitée par ces surfaces peut être réalisée de manière relativement simple.

De préférence, en outre tout point de la deuxième surface de la pale, autre que la première surface, et tout point desdites parties des veines de pied et de talon situées du côté de la deuxième surface présente une normale formant un angle aigu ou droit par rapport à une direction dite deuxième direction de fabrication.

Grâce à cela, l'aube peut être fabriquée de manière relativement simple puisque la surface de l'aube présente une première partie du côté de la première surface dont les surfaces ne présentent pas de contre-dépouille vis-à-vis de la première direction de fabrication, et une deuxième partie du côté de la deuxième surface dont les surfaces ne présentent pas de contre-dépouille vis-à-vis de la deuxième direction de fabrication. Ainsi, la réalisation de ces deux parties est relativement facile.

Cela étant, il résulte de la conception de l'aube que la veine présente généralement une discontinuité de pente de part et d'autre de la courbe de crête.

Cependant, une partie de la courbe de crête est située à l'intérieur de la pale : il s'ensuit qu'une partie de cette discontinuité ne se produit pas sur les veines elles-mêmes et ne perturbe pas la circulation de fluide à la surface des plateformes.

Inversement à l'extérieur de la pale, ce mode de réalisation peut avoir pour conséquence que la plateforme de pied et/ou la plateforme de talon présente une arête ou plutôt éventuellement, deux portions d'arête, une en amont de la pale, et l'autre en aval de la pale. Ces arêtes constituent les portions amont et aval de la courbe de crête séparant la veine en une partie d'intrados et une partie d'extrados.

L'arête amont s'étend alors de la pale (en général, du bord d'attaque de la pale) jusqu'au bord amont de la plateforme considérée ; l'arête aval s'étend de la pale (du bord de fuite) au bord aval de la plateforme considérée. La courbe de crête citée précédemment et qui sépare les parties de veine (de talon ou de pied) situées du côté respectivement de l'intrados et de l'extrados, suit ces arêtes amont et aval.

Il s'est avéré avantageusement que la présence d'arêtes en amont du bord d'attaque de la pale, ou en aval du bord de fuite de celle-ci, ne dégrade généralement pas de manière importante les performances de l'aube.

Pour simplifier la fabrication des aubes, de préférence la première et la deuxième direction de fabrication sont, en vue radiale, parallèles de sens opposés.

D'autre part, pour simplifier la fabrication des aubes, de préférence la première et la deuxième direction de fabrication sont symétriques par rapport à un plan médian de la pale (Par 'plan médian de la pale', on désigne ici un plan voisin d'un plan moyen de la pale).

Par ailleurs, la fabrication de l'aube est facilitée lorsqu'une grande partie de la surface de la veine présente une dépouille suffisante vis-à-vis de la direction de fabrication envisagée pour la surface considérée. Inversement, la dépouille sur la veine doit de préférence rester aussi faible que possible, pour ne pas perturber l'écoulement aérodynamique du fluide au voisinage de la veine.

Pour concilier ces exigences de manière optimale, dans un mode de réalisation sur une partie de l'étendue axiale de l'aube, voire sur toute l'étendue axiale de l'aube, une section de la partie d'intrados et/ou de la partie d'extrados d'une desdites veines suivant un plan contenant une direction radiale pour l'aube et la première direction de fabrication est constituée par un segment de droite.

L'aube est prévue pour être intégrée à une roue à aubes de turbomachine comportant un nombre d'aubes prédéterminé, noté N.

Dans un mode de réalisation, l'arête délimitant la veine d'une plateforme (dite 'première plateforme' ; elle peut être la plateforme de pied ou de talon) du côté intrados est sensiblement confondue avec l'arête délimitant la veine de la première plateforme du côté extrados, à une rotation de 360/N° près. (Le même agencement peut être adopté pour l'autre plateforme, si l'aube comporte deux plateformes).

Par suite avantageusement, lorsque deux aubes de ce type sont placées l'une à côté de l'autre (une première et une deuxième aube), dans la même position que lorsqu'elles sont assemblées dans la roue à aubes, la discontinuité de pente entre la première plateforme du côté de l'intrados de la première aube, et la première plateforme du côté de l'extrados de la deuxième aube, à l'interface entre les deux aubes, se produit dans le creux formé à l'interface entre les deux aubes.

Comme cette zone est en creux, la discontinuité de pente à cet endroit ne perturbe pas excessivement l'écoulement du fluide entre les aubes, et ne réduit pas de manière inacceptable la performance de la roue à aubes.

L'invention concerne également une roue à aubes, comprenant une pluralité d'aubes telles que définies précédemment, ainsi qu'une turbomachine, en particulier une turbine basse pression, comportant une telle roue à aubes.

Un deuxième objectif de l'invention est de proposer un procédé de modélisation d'une aube comportant successivement un pied, une pale, et un talon, une surface externe de la pale étant constituée par un extrados et un intrados, permettant de définir une aube particulièrement facile à fabriquer, notamment en comparaison par rapport aux aubes antérieures.

Cet objectif est atteint lorsque la modélisation de la veine d'aube est faite en suivant les étapes ci-dessous :
a) on crée un modèle CAO d'une première surface parmi l'intrados et l'extrados de telle manière que tout point de la première surface présente une normale formant un angle aigu ou droit par rapport à une direction dite première direction de fabrication ; et
b) on crée un modèle CAO des veines de pied et de talon de l'aube, de telle manière que chacune desdites veines est constituée par une partie d'intrados du côté de l'intrados et une partie d'extrados du côté de l'extrados, séparées par une courbe de crête allant d'un bord amont à un bord aval de la veine en traversant la pale, chacune desdites veines présentant ainsi une discontinuité de pente de part et d'autre de la courbe de crête ; et que tout point de la première surface et tout point desdites parties des veines de pied et de talon situées du côté de la première
surface présente une normale formant un angle aigu ou droit par rapport à la première direction de fabrication.

Ce procédé permet de créer le modèle CAO d'une aube telle que définie précédemment. Par 'modèle CAO' on entend un modèle numérique tridimensionnel tel qu'on peut notamment en créer au moyen d'un logiciel de Conception Assistée par Ordinateur.

Une méthode particulièrement efficace pour créer les veines consiste à créer celles-ci à partir d'une part, d'une courbe 'de crête' située au niveau de la pale (circonférentiellement), et d'autre part de courbes de limitation qui délimitent la veine du côté intrados et extrados respectivement à ses interfaces avec les aubes adjacentes.

Le modèle CAO d'une des veines (de pied ou de talon) peut notamment être créé à partir d'une courbe de crête, créée ou obtenue par une translation ou un décalage d'une courbe de construction.

La courbe de construction peut par exemple être créée sur une surface théorique de veine représentant une forme théorique de carter idéale pour le passage du fluide.

On peut également créer sur la surface théorique de veine des courbes délimitant deux aubes adjacentes, c'est-à-dire des courbes de limitation.

La courbe de construction et les courbes de limitation ainsi créées sont radialement sensiblement au même niveau. Pour cette raison, on crée la courbe de crête en translatant ou en décalant radialement la courbe de construction : cette opération permet de créer une différence de position radiale entre ces courbes, ce qui permettra comme cela va être expliqué plus loin, d'assurer la présence d'une dépouille suffisante sur la surface de veine créée.

De préférence, la courbe de construction est créée de telle manière que celle-ci traverse de part en part la surface théorique de pale. Ainsi comme expliqué précédemment, la discontinuité de pente qui se produit généralement au niveau de la courbe de crête se trouve en partie masquée par le fait qu'elle a lieu de part et d'autre de la pale.

Concernant maintenant les courbes de limitation, on peut en créer deux comme expliqué précédemment, à savoir une du côté intrados et une du côté extrados.

Cependant de préférence on crée les courbes de limitation de telle manière que la courbe de limitation délimitant la veine du côté intrados soit confondue (au jeu inter-aubes près) avec la courbe de limitation délimitant la veine du côté extrados, à une rotation de 360/N° près.

La construction des veines peut être faite de différentes manières.

Dans un mode de réalisation, le modèle CAO d'au moins une desdites parties d'une desdites veines est obtenu par un balayage d'un segment de droite se déplaçant en s'appuyant sur deux courbes.

Le terme 's'appuyant sur' signifie ici que le segment de droite est à chaque instant en contact avec les deux courbes.

Le segment de droite se déplace en restant à tout instant dans un plan perpendiculaire à l'axe de la roue.

La première des courbes utilisées pour le balayage est de préférence la courbe de crête décrite précédemment.

La deuxième de ces courbes est de préférence la courbe de limitation décrite précédemment.

De préférence, les deux côtés de l'aube sont modélisés suivant la méthode décrite précédemment.

Dans ce cas, alors qu'un premier côté de l'aube est modélisé suivant le procédé décrit précédemment, on modélise le deuxième côté de l'aube en réalisant l'étape ci-dessous :
c) on crée un modèle CAO de la deuxième surface parmi l'intrados et l'extrados (autre que la première surface), de telle manière que tout point de la deuxième surface présente une normale formant un angle aigu ou droit par rapport à une direction dite deuxième direction de fabrication ; et à l'étape b), on crée le modèle CAO des veines de pied et de talon de telle manière que tout point des veines de pied et de talon du côté de la deuxième surface présente une normale formant un angle aigu ou droit par rapport à la deuxième direction de fabrication.

Dans un mode de mise en oeuvre, la première et la deuxième (ou seconde) direction de fabrication sont identiques.

L'invention concerne également un procédé de fabrication d'une aube pour roue à aubes de turbomachine, comprenant un pied, un talon et une pale, caractérisé en ce qu'il utilise, pour définir l'aube, un procédé de modélisation tel que défini précédemment.

L'invention concerne également l'utilisation, dans l'outil de CAO CATIA (marque déposée), du procédé de modélisation de veine tel que défini précédemment.

Elle concerne enfin un programme d'ordinateur comportant des instructions pour l'exécution par ordinateur des étapes du procédé de modélisation d'aube tel que défini précédemment, un support d'enregistrement lisible par un ordinateur sur lequel est enregistré un programme d'ordinateur tel que défini précédemment, et un ordinateur comportant un support d'enregistrement tel que défini précédemment.

L'invention sera bien comprise et ses avantages apparaîtront mieux à la lecture de la description détaillée qui suit, de modes de réalisation représentés à titre d'exemples non limitatifs. La description se réfère aux dessins annexés, sur lesquels :
- La figure 1 est une vue schématique en perspective d'une aube selon l'invention.
- La figure 2 est une vue schématique partielle en perspective d'une turbomachine, montrant une roue à aubes comportant des aubes identiques à celles illustrées par la figure 1.
- La figure 3 est une vue schématique en perspective du modèle numérique de l'aube de la figure 1 en cours de création par le procédé de modélisation selon l'invention.
- La figure 4 est une vue schématique radiale par rapport à l'axe de la roue à aubes, du modèle numérique de l'aube de la figure 1 en cours de création par le procédé de modélisation selon l'invention.
- La figure 5 est une vue schématique suivant l'axe de la roue à aubes, du modèle numérique de l'aube de la figure 1 en cours de création par le procédé de modélisation selon l'invention.

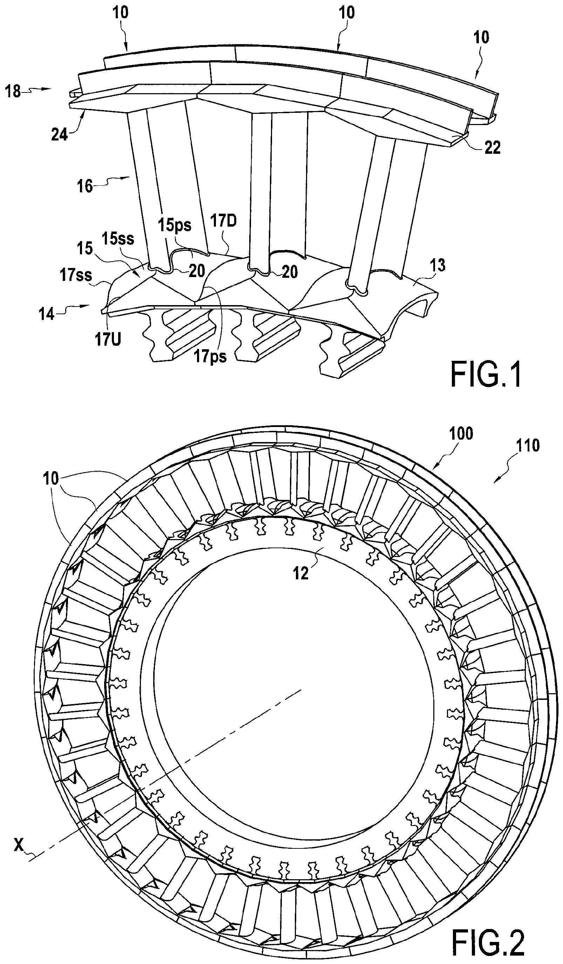

La figure 1 représente trois aubes 10 identiques qui représentent un mode de réalisation de l'invention. Chacune de ces aubes 10 est conçue pour être assemblée avec N-1 aubes 10 identiques, de manière à former une roue à aubes 100 comprenant N aubes 10 (Fig. 2).

La roue à aubes 100 fait elle-même partie d'une turbomachine 110.

Dans la roue 100, les aubes 10 sont montées sur un disque rotor 12 de manière axisymétrique autour de l'axe X de la roue. Lorsque la roue est exploitée, un flux de fluide s'écoule suivant l'axe X d'un côté amont à un côté aval de la roue.

Dans ce qui suit, les éléments associés au côté amont sont notés 'u', et les éléments associés au côté aval sont notés 'd'.

Chaque aube 10 comporte successivement, suivant une direction radiale sortante de la roue, un pied 14, une pale 16, et un talon 18.

Le pied 14 et le talon 18 constituent donc les deux extrémités de l'aube. Ils comportent respectivement une plateforme 13 et une plateforme 22. Ces plates-formes 13,22 s'étendent dans une direction globalement perpendiculaire à la direction longitudinale de la pale 16 (qui est la direction radiale R pour l'aube 10).

La plateforme 13 de pied présente une veine 15, et la plateforme 22 de talon une veine 24.

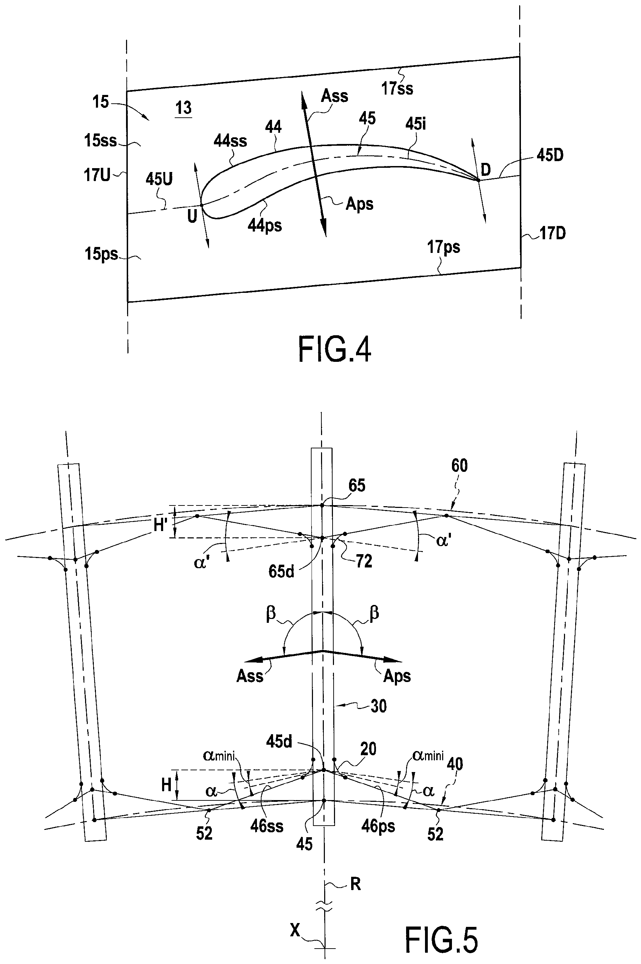

Suivant une vue radiale (suivant la direction R, comme représenté sur la figure 4), la veine 15 présente un contour externe à quatre côtés, délimité par un bord amont 17u, un bord aval 17d, un bord d'intrados 17ps, un bord d'extrados 17ss. (Les éléments du côté intrados sont notés 'ps', et les éléments du côté extrados notés 'ss').

La veine 15 est constituée de deux parties complémentaires : une partie d'intrados 15ps située du côté de l'intrados, et une partie d'extrados 15ss située du côté de l'extrados de la pale.

Ces deux parties 15ps,15ss sont délimitées par une courbe de crête 45c.

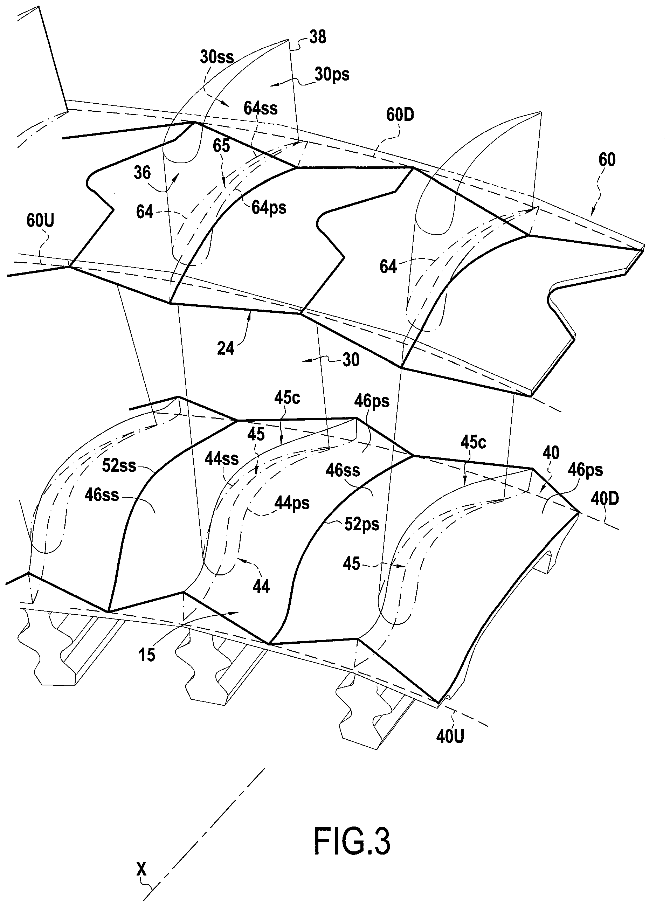

La veine 15 est reliée à la surface de la pale 16 par des surfaces de raccordement 20 (qui sont des congés de raccordement à rayon évolutif), non représentées sur la figure 3.

Le procédé de modélisation utilisé pour définir la forme de l'aube 10 conformément à l'invention va maintenant être présenté.

Ce procédé comporte les opérations suivantes :
a) Détermination de la surface théorique de pale
b) Détermination de la surface théorique de veine
c) Définition de la courbe de construction pour l'aube
d) Création de la veine.

Ces opérations sont réalisées sur ordinateur, à l'aide d'un programme de conception assistée par ordinateur comme par exemple le logiciel CATIA (marque déposée).

Les différentes opérations de création indiquées ci-après sont donc des opérations de création d'entités tridimensionnelles, qui sont définies dans un environnement ou un espace tridimensionnel virtuel.

### a) Détermination d'une surface théorique de pale

On crée tout d'abord une surface théorique 30 de pale. Cette surface représente la surface externe souhaitée pour la pale 16. Cette surface est fonction notamment des contraintes aérodynamiques applicables à la pale ; elle est constituée par un extrados 30ss et un intrados 30ps, et présente un bord d'attaque 36 et un bord de fuite 38 (Fig.3).

### b) Détermination des surfaces théoriques de veine

On crée ou on détermine ensuite une surface théorique 40 de veine de pied et une surface théorique 60 de veine de talon. Chacune de ces surfaces a sensiblement la forme souhaitée pour le carter, respectivement intérieur ou extérieur, délimitant le passage de circulation de gaz à travers la roue à aubes.

Les surfaces 40, 60 s'étendent axialement vers l'amont et l'aval jusqu'à des courbes de crêtes (40U, 40D, 60U, 60D) qui délimitent axialement l'étendue ou l'emprise de l'aube que l'on souhaite définir.

Dans l'exemple présenté, les surfaces 40 et 60 sont des surfaces de révolution définies autour de l'axe A. Cela étant, des surfaces théoriques pour la veine qui ne sont pas des surfaces de révolution peuvent également être utilisées dans le cadre de l'invention, par exemple des surfaces conduisant à définir des plateformes dites 'plateformes 3D' et comportant localement des bosses et/ou des creux.

Une surface de révolution autour d'un axe désigne ici une surface engendrée par la rotation d'une courbe autour de cet axe.

### c) Création des courbes de construction de veine

Après avoir défini les entités support que sont les surfaces théoriques de pale (30) et de veine (40,60), on crée les courbes de construction 45,65 respectivement pour la veine de la plateforme 13 et pour la veine de la plateforme 22.

Pour cela, on détermine la courbe d'intersection 44 entre la surface théorique de pale 30 et la surface théorique 40 de veine de pied.

On détermine également la courbe d'intersection 64 entre la surface théorique de pale 30 et la surface théorique 60 de veine de talon.

On définit ensuite les directions de fabrication Aps et Ass pour l'aube, respectivement du côté de l'intrados et de l'extrados.

Dans le mode de mise en oeuvre de l'invention présenté, les première et deuxième direction de fabrication Aps et Ass sur les deux côtés de l'aube sont choisies symétriques par rapport au plan contenant la direction R et perpendiculaire à l'axe X, ce qui simplifie l'outillage de fabrication. Les directions de fabrication correspondent aux directions de démoulage, d'usinage ou autre, en fonction du procédé de fabrication utilisé.
Par suite, en vue axiale (dans un plan perpendiculaire à l'axe X de la roue à aubes, comme représenté sur la figure 5), les directions de fabrication Aps et Ass forment un même angle β par rapport à la direction radiale R.

La détermination de la courbe de construction 45 pour la plateforme de pied 13 va maintenant être présentée en détail, la même méthode étant utilisée ensuite pour déterminer la courbe de construction 65 pour la plateforme de talon 22.

Pour une courbe d'intersection donnée entre la surface théorique de pale et une surface théorique de veine (dans le cas présent, la courbe d'intersection est la courbe 44), aux directions de fabrication (Aps,Ass) correspond un couple de points (U,D) dits 'points limites' qui se définit de la manière suivante :
Un couple de points limites (U,D) est le couple de points, généralement situés respectivement aux voisinages du bord d'attaque 36 et du bord de fuite 38 de la pale, qui font partie de la courbe d'intersection considérée (44), et qui divisent celle-ci en deux portions complémentaires (44ps et 44ss) du côté respectivement intrados et extrados, et telles qu'en tout point de chacune de ces portions (44ps et 44ss), l'angle entre la normale à la surface théorique de pale au point considéré forme un angle aigu ou droit par rapport à la direction de fabrication A.

En d'autres termes, en chaque point de l'une de ces portions de courbe, la surface théorique de pale présente une dépouille non négative par rapport à la direction de fabrication.

Cela entraîne en général qu'en vue radiale (c'est-à-dire suivant la direction radiale de la pale comme illustré par la figure 4), la tangente à la courbe d'intersection (à la courbe 44) aux points limites (U,D) est parallèle aux directions de fabrication Aps et Ass, comme illustré sur la figure 4.

Le choix des directions de fabrication Aps et Ass permet de définir un couple de points limites U,D sur la courbe 44.

On définit alors la courbe de construction 45 pour la plateforme de pied de manière à respecter les contraintes suivantes :
- la courbe 45 doit passer par les points limites U et D ;
- elle doit se prolonger en amont et en aval jusqu'aux courbes de crêtes amont et aval respectives 40U et 40D de la surface théorique de veine 40 ; et
- elle doit relier les points U et D sans traverser la surface théorique de pale 30 entre ces points.

La courbe de construction 45 comporte donc :
- une partie 45i à l'intérieur de la courbe 44, dont les extrémités sont les points U et D. En vue radiale (Fig.4), cette partie de courbe 45i s'étend à l'intérieur de la courbe 44.
- deux portions de courbe, 45u et 45d, qui sont formées sur la surface théorique de veine de pied 40 respectivement du point U à la courbe 40u et du point D à la courbe 40d.

La courbe de construction 65 pour la plateforme de talon 22 est créée ensuite de manière analogue.

### d) Création des veines de pied et de talon

Les veines de pied et de talon sont créées de la manière suivante. Seule est décrite la création de la veine de pied, la veine de talon étant créée de manière analogue.

On crée d'abord la courbe de limitation (notée de manière générique courbe 52) souhaitée pour délimiter les plateformes d'aubes adjacentes. Plus précisément, deux instances 52ps et 52ss de cette courbe de limitation 52 sont créées, l'une du côté de l'intrados et l'autre du côté de l'extrados de la surface théorique de pale 30, ces deux courbes étant identiques l'une à l'autre à une rotation d'angle 360°/N autour de l'axe X près. Ces courbes 52ps et 52ss sont créées en surface de la surface théorique de veine 40.

On crée une courbe de crête 45c en décalant radialement dans le sens centrifuge la courbe 45 d'une hauteur H dont la valeur est précisée ci-dessous.

On crée alors des surfaces support de veine 46ps et 46ss par balayage de segments de droite se déplaçant, de part et d'autre de la surface théorique de pale, en appui sur d'une part la courbe de crête 45c, et d'autre part sur respectivement la courbe 52ps et la courbe 52ss.

A chaque instant, chacun de ces segments de droite reste contenu dans un plan P perpendiculaire à l'axe X de la roue.

La valeur H du décalage radial de la courbe 45c est choisie comme étant suffisante pour que les surfaces support de veine 46ps et 46ss aient, dans tout plan P, une dépouille suffisante vis-à-vis de la direction de démoulage A : c'est-à-dire qu'en chacun des plans P, l'angle α entre un point de la section de la surface support de veine et la direction de démoulage A doit être supérieur à l'angle minimum de dépouille souhaité αₘᵢₙᵢ (Dans un cas limite, l'angle minimum de dépouille souhaité αₘᵢₙᵢ peut être égal à 0).

Par ailleurs, dans tous les cas il ne doit pas y avoir de contre-dépouille : Ainsi en chaque point de chacune des surfaces support de veine 46ps et 46ss, l'angle entre la normale au point considéré et la direction de fabrication pour la surface support de veine dont le point fait partie doit former un angle aigu ou droit, mais en aucun cas un angle obtus (>90°).

Comme les surfaces 46ps et 46ss sont créées par balayage de segments de droite contenus dans des plans P et se déplaçant en appui sur deux courbes, leurs sections dans un plan P quelconque sont des segments de droite.

Les surfaces 46ps et 46ss cependant peuvent également, tout en restant dans le cadre de l'invention, être créées par toute autre méthode appropriée de création de surface.

Il convient notamment de s'assurer que la condition précédente est respectée dans chacun des plans P, c'est-à-dire que dans chacun de ces plans, l'angle entre un point quelconque de la section de la surface support de veine et la direction de fabrication concernée (Aps ou Ass) est supérieur à l'angle minimum de dépouille souhaité αₘᵢₙᵢ.

La construction des surfaces 46ps et 46ss par balayage d'un segment de droite en appui sur deux courbes, comme présenté précédemment, a pour conséquence que les surfaces 46ps et 46ss de deux aubes adjacentes présentent une limite commune, délimitée par une courbe 52.

Si une autre méthode que celle-ci est utilisée pour créer les surfaces 46ps et 46ss, il est souhaitable que les surfaces 46ps et 46ss soient formées de telle sorte qu'il n'y ait pas de discontinuité (au moins de position) entre deux aubes adjacentes : cela signifie que les bords opposés à la pale des surfaces 46ps et 46ss doivent se correspondre (ou être en vis-à-vis) à une rotation de 360°/n degrés près.

Sur l'aube 10, cela entraîne que les arêtes délimitant la veine 15 respectivement du côté intrados et du côté extrados (référencées 17ps et 17ss, et qui toutes deux sont géométriquement définies à partir de la courbe 52) sont sensiblement confondues, à une rotation de 360/N° près.

Une fois les surfaces support de veine 46ps et 46ss créées, elles doivent être limitées.

Pour cela, on calcule d'abord les surfaces 20 des congés de raccordement entre la surface théorique de pale 30 et les surfaces support de veine 46ps et 46ss. On limite les surfaces support de veine 46ps,46ss à l'extrémité des surfaces 20 de congés de raccordement.

Cependant, en amont et en aval de la surface théorique de pale 30, les surfaces support de veine 46ps et 46ss se rejoignent au niveau des portions de courbe 45u et 45d de la courbe de crête 45c.

La réunion des surfaces 46ps et 46ss ainsi limitées constitue la veine 15 de la plateforme 13.

La veine de talon 24 est créée de la même manière, de même que les congés de raccordement 72 entre la veine 24 et la surface théorique de pale 30.

Lors de la création de la veine de talon 24, on est donc amené à créer une courbe de crête 65c, en décalant radialement la courbe 65 d'une valeur H' (qui n'est pas nécessairement égale à H).

Le décalage radial est naturellement effectué en direction de l'axe X.

Par suite, du côté de l'intrados comme du côté de l'extrados et dans la mesure où la courbe 45 a été décalée d'une hauteur H suffisante, les surfaces support de veine des plateformes de talon et de pied présentent dans tout plan P une dépouille suffisante par rapport à la direction de fabrication A.

### Finalisation du modèle de l'aube

Le modèle numérique de l'aube complet est alors finalisé en intégrant dans celui-ci notamment les veines 15 et 24, les congés de raccordement 20 et 72, et la surface théorique de pale 30, une fois les limitations apportées.

### Fabrication des aubes

L'aube 10 peut alors être industrialisée et fabriquée avec la géométrie définie par le modèle CAO ainsi défini.

## Revendications

1. Aube (10) pour roue à aubes (100) de turbomachine ; l'aube comportant successivement, suivant une direction radiale sortante de la roue, un pied (14), une pale (16), et un talon (18) ;
le pied (14) comportant une plateforme (13) de pied présentant une surface (15), dite veine de pied, du côté de la pale ;
le talon (18) comportant une plateforme (22) de talon présentant une surface (24), dite veine de talon, du côté de la pale ;
la pale (16) comportant une surface externe dite surface de pale (30) comportant un intrados (30ps) et un extrados (30ss) ;
l'aube **se caractérisant en ce que**
chacune desdites veines est constituée par une partie d'intrados (15ps,24ps) du côté de l'intrados et une partie d'extrados (15ss,24ss) du côté de l'extrados, séparées par une courbe de crête (45,65) allant d'un bord amont (15U,24U) à un bord aval (15D,24D) de la veine en traversant la pale, de telle sorte que chacune desdites veines présente une discontinuité de pente de part et d'autre de la courbe de crête (45,65) ; et **en ce que**
tout point d'une première surface parmi l'intrados et l'extrados et tout point desdites parties des veines de pied et de talon situées du côté de la première surface présente une normale formant un angle aigu ou droit par rapport à une direction dite première direction de fabrication (Aps).

2. Aube selon la revendication 1, dans laquelle tout point de la deuxième surface de la pale, autre que la première surface, et tout point desdites parties des veines de pied et de talon situées du côté de la deuxième surface présente une normale formant un angle aigu ou droit par rapport à une direction dite deuxième direction de fabrication.

3. Aube selon la revendication 2, dans laquelle, en vue radiale, la première et la deuxième direction de fabrication sont parallèles de sens opposés.

4. Aube selon l'une quelconque des revendications 1 à 3, dans laquelle sur une partie de l'étendue axiale de l'aube, ou notamment sur toute l'étendue axiale de l'aube, une section de la veine de pied ou de la veine de talon sur le premier côté suivant un plan contenant une direction sensiblement radiale pour l'aube et la première direction de fabrication est principalement constituée par un segment de droite.

5. Aube selon l'une quelconque des revendications 1 à 4, prévue pour une roue à aubes (100) de turbomachine comportant N aubes, et dans laquelle une arête délimitant la veine d'une première plateforme de l'aube du côté intrados est sensiblement confondue avec une arête délimitant la veine de la première plateforme du côté extrados, à une rotation de 360/N° près.

6. Roue à aubes (100), comprenant une pluralité d'aubes (10) suivant l'une quelconque des revendications 1 à 5.

7. Turbomachine (110), en particulier turbine basse pression, comportant une roue à aubes (100) selon la revendication 6.

8. Procédé de modélisation d'une aube comportant successivement un pied, une pale, et un talon, une surface externe de la pale étant constituée par un extrados et un intrados, le pied (14) comportant une plateforme (13) de pied présentant une surface (15), dite veine de pied, du côté de la pale, le talon (18) comportant une plateforme (22) de talon présentant une surface (24), dite veine de talon, du côté de la pale, la pale (16) comportant une surface externe dite surface de pale (30) comportant un intrados (30ps) et un extrados (30ss) ;
le procédé **se caractérisant en ce qu'**il comporte les étapes suivantes :
a) on crée un modèle CAO d'une première surface parmi l'intrados et l'extrados de telle manière que tout point de la première surface présente une normale formant un angle aigu ou droit par rapport à une direction dite première direction de fabrication ; et
b) on crée un modèle CAO des veines de pied et de talon de l'aube, de telle manière que chacune desdites veines est constituée par une partie d'intrados (15ps,24ps) du côté de l'intrados et une partie d'extrados (15ss,24ss) du côté de l'extrados, séparées par une courbe de crête (45,65) allant d'un bord amont (15u,24u) à un bord aval (15d,24d) de la veine en traversant la pale, chacune desdites veines présentant ainsi une discontinuité de pente de part et d'autre de la courbe de crête (45,65), et que tout point de la première surface et tout point desdites parties des veines de pied et de talon situées du côté de la première surface présente une normale formant un angle aigu ou droit par rapport à la première direction de fabrication.

9. Procédé de modélisation selon la revendication 8, dans lequel à l'étape b), on crée le modèle CAO d'une desdites veines à partir de la courbe de crête (45c), qui est obtenue par une translation ou un décalage d'une courbe de construction (45).

10. Procédé de modélisation selon la revendication 9, dans lequel à l'étape b), on crée la courbe de construction de telle manière que celle-ci traverse de part en part une surface théorique de pale (30).

11. Procédé de modélisation selon l'une quelconque des revendications 8 à 10, dans lequel à l'étape b), on crée une desdites veines de telle manière qu'une courbe de limitation délimitant ladite veine du côté intrados soit sensiblement confondue avec une courbe de limitation délimitant ladite veine du côté extrados, à une rotation de 360/N° près.

12. Procédé de modélisation selon l'une quelconque des revendications 8 à 11, dans lequel à l'étape b), le modèle CAO d'au moins une desdites parties d'une desdites veines est obtenu par un balayage d'un segment de droite se déplaçant en appui sur deux courbes (45c;52ps,52ss).

13. Procédé de modélisation d'une aube, suivant lequel on modélise un premier côté d'une aube suivant le procédé selon l'une quelconque des revendications 8 à 12 ; le procédé comprenant en outre l'étape suivante :
c) on crée un modèle CAO d'une deuxième surface parmi l'intrados et l'extrados, autre que la première surface, de telle manière que tout point de la deuxième surface présente une normale formant un angle aigu ou droit par rapport à une direction dite deuxième direction de fabrication ; et dans lequel à l'étape b), on crée le modèle CAO des veines de pied et de talon de telle manière que tout point des veines de pied et de talon du côté de la deuxième surface présente une normale formant un angle aigu ou droit par rapport à la deuxième direction de fabrication.

14. Procédé de modélisation suivant la revendication 13, dans lequel la première et la seconde direction de fabrication sont identiques.

15. Procédé de fabrication d'une aube pour roue à aubes de turbomachine, comprenant un pied, un talon et une pale, **caractérisé en ce qu'**il utilise, pour définir l'aube, un procédé de modélisation selon l'une quelconque des revendications 8 à 14.

## Patentansprüche

1. Schaufel (10) für ein Schaufelrad (100) einer Turbomaschine, wobei die Schaufel nacheinander, in einer radialen Ausgangsrichtung des Rades, einen Fuß (14), ein Blatt (16) und ein Deckband (18) aufweist,
wobei der Fuß (14) eine Fußplattform (13) umfasst, die eine Fläche (15), sogenannten Fußkanal, auf der Seite des Blattes aufweist,
wobei das Deckband (18) eine Deckbandplattform (22) umfasst, die eine Fläche (24), sogenannten Deckbandkanal, auf der Seite des Blattes aufweist,
wobei das Blatt (16) eine Außenfläche, sogenannte Blattfläche (30) mit einer Vorderseite (30ps) und einer Rückseite (30ss) aufweist,
wobei die Schaufel **dadurch gekennzeichnet ist, dass**
ein jeder der Kanäle durch einen Vorderseitenteil (15ps, 24ps) auf der Seite der Vorderseite und einen Rückseitenteil (15ss, 24ss) auf der Seite der Rückseite gebildet ist, die durch eine Scheitelkurve (45, 65), welche von einer stromaufwärtigen Kante (15U, 24U) unter Durchqueren des Blattes zu einer stromabwärtigen Kante (15D, 24D) des Kanals verläuft, getrennt sind, so dass ein jeder der Kanäle eine Neigungsunterbrechung auf beiden Seiten der Scheitelkurve (45, 65) aufweist, und dass
jeder Punkt einer ersten Fläche aus Vorderseite und Rückseite und jeder Punkt der Teile der Fuß- und Deckbandkanäle, die auf der Seite der ersten Fläche gelegen sind, eine Normale aufweist, die in Bezug auf eine Richtung, sogenannte erste Fertigungsrichtung (Aps) einen spitzen oder rechten Winkel bildet.

2. Schaufel nach Anspruch 1, bei der jeder Punkt der zweiten Fläche des Blattes, anders als die erste Fläche, und jeder Punkt der Teile der Fuß- und Deckbandkanäle, die auf der Seite der zweiten Fläche gelegen sind, eine Normale aufweist, die in Bezug auf eine Richtung, sogenannte zweite Fertigungsrichtung einen spitzen oder rechten Winkel bildet.

3. Schaufel nach Anspruch 2, bei der in radialer Ansicht die erste und die zweite Fertigungsrichtung parallel mit entgegengesetzten Richtungen sind.

4. Schaufel nach einem der Ansprüche 1 bis 3, bei der über einen Teil der axialen Erstreckung der Schaufel oder insbesondere über die gesamte axiale Erstreckung der Schaufel ein Abschnitt des Fußkanals oder des Deckbandkanals auf der ersten Seite in einer Ebene, die eine im Wesentlichen radiale Richtung für die Schaufel und die erste Fertigungsrichtung enthält, hauptsächlich durch ein Geradensegment gebildet ist.

5. Schaufel nach einem der Ansprüche 1 bis 4, die für ein Schaufelrad (100) einer Turbomaschine mit N Schaufeln vorgesehen ist und bei der eine Kante, welche den Kanal einer ersten Plattform der Schaufel auf der Vorderseite begrenzt, mit einer Kante, die den Kanal der ersten Plattform auf der Rückseite begrenzt, bis auf eine Drehung von 360°/N im Wesentlichen verschmolzen ist.

6. Schaufelrad (100), das eine Vielzahl von Schaufeln (10) nach einem der Ansprüche 1 bis 5 umfasst.

7. Turbomaschine (110), insbesondere Niederdruckturbine, die ein Schaufelrad (100) nach Anspruch 6 umfasst.

8. Verfahren zur Modellierung einer Schaufel, die nacheinander einen Fuß, ein Blatt und ein Deckband aufweist, wobei eine Außenfläche des Blattes durch eine Rückseite und eine Vorderseite gebildet ist, wobei der Fuß (14) eine Fußplattform (13) mit einer Fläche (15), sogenannten Fußkanal, auf der Seite des Blattes umfasst, wobei das Deckband (18) eine Deckbandplattform (22) umfasst, die eine Fläche (24), sogenannten Deckbandkanal, auf der Seite des Blattes aufweist, wobei das Blatt (16) eine Außenfläche, sogenannte Blattfläche (30) mit einer Vorderseite (30ps) und einer Rückseite (30ss) aufweist,
wobei das Verfahren **dadurch gekennzeichnet ist, dass** es die folgenden Schritte umfasst:
a) ein CAD-Modell einer ersten Fläche aus Vorderseite und Rückseite derart erstellt wird, dass jeder Punkt der ersten Fläche eine Normale aufweist, die in Bezug auf eine Richtung, sogenannte erste Fertigungsrichtung einen spitzen oder rechten Winkel bildet, und
b) ein CAD-Modell der Fuß- und Deckbandkanäle der Schaufel derart erstellt wird, dass ein jeder der Kanäle durch einen Vorderseitenteil (15ps, 24ps) auf der Seite der Vorderseite und einen Rückseitenteil (15ss, 24ss) auf der Seite der Rückseite gebildet wird, die durch eine Scheitelkurve (45, 65), welche von einer stromaufwärtigen Kante (15u, 24u) unter Durchqueren des Blattes zu einer stromabwärtigen Kante (15d, 24d) des Kanals verläuft, getrennt sind, wobei ein jeder der Kanäle somit eine Neigungsunterbrechung auf beiden Seiten der Scheitelkurve (45, 65) aufweist, und dass jeder Punkt der ersten Fläche und jeder Punkt der Teile der Fuß- und Deckbandkanäle, die auf der Seite der ersten Fläche gelegen sind, eine Normale aufweist, die in Bezug auf die erste Fertigungsrichtung einen spitzen oder rechten Winkel bildet.

9. Modellierungsverfahren nach Anspruch 8, wobei in Schritt b) das CAD-Modell von einem der Kanäle anhand der Scheitelkurve (45c) erstellt wird, die durch eine Verschiebung oder einen Versatz einer Konstruktionskurve (45) erhalten wird.

10. Modellierungsverfahren nach Anspruch 9, wobei in Schritt b) die Konstruktionskurve derart erstellt wird, dass diese eine theoretische Blattfläche (30) vollkommen durchquert

11. Modellierungsverfahren nach einem der Ansprüche 8 bis 10, wobei in Schritt b) einer der Kanäle derart erstellt wird, dass eine Begrenzungskurve, welche den Kanal auf der Vorderseite begrenzt, mit einer Begrenzungskurve, die den Kanal auf der Rückseite begrenzt, bis auf eine Drehung von 360°/N im Wesentlichen verschmolzen ist.

12. Modellierungsverfahren nach einem der Ansprüche 8 bis 11, wobei in Schritt b) das CAD-Modell von wenigstens einem der Teile eines der Kanäle durch ein Abtasten eines Geradensegments, das sich in Anlage an zwei Kurven (45c; 52ps, 52ss) bewegt, erhalten wird.

13. Verfahren zur Modellierung einer Schaufel, wonach eine erste Seite einer Schaufel gemäß dem Verfahren nach einem der Ansprüche 8 bis 12 modelliert wird, wobei das Verfahren ferner den folgenden Schritt umfasst:
c) Erstellen eines CAD-Modells einer zweiten Fläche aus Vorderseite und Rückseite, anders als die erste Fläche, derart, dass jeder Punkt der zweiten Fläche eine Normale aufweist, die in Bezug auf eine Richtung, sogenannte zweite Fertigungsrichtung einen spitzen oder rechten Winkel bildet, und wobi in Schritt b) das CAD-Modell der Fuß- und Deckbandkanäle derart erstellt wird, dass jeder Punkt der Fuß- und Deckbandkanäle auf der Seite der zweiten Fläche eine Normale aufweist, die in Bezug auf die zweite Fertigungsrichtung einen spitzen oder rechten Winkel bildet.

14. Modellierungsverfahren nach Anspruch 13, wobei die erste und die zweite Fertigungsrichtung gleich sind.

15. Verfahren zur Herstellung einer Schaufel für ein Schaufelrad einer Turbomaschine, umfassend einen Fuß, ein Deckband und ein Blatt, **dadurch gekennzeichnet, dass** es zur Definition der Schaufel ein Modellierungsverfahren nach einem der Ansprüche 8 bis 14 verwendet.

## Claims

1. A blade (10) for a turbomachine bladed wheel (100); the blade comprising in succession in an outward radial direction of the wheel, a root (14), an airfoil (16), and a tip (18);
the root (14) having a root platform (13) presenting a surface (15) on a side toward the airfoil, which surface is referred to as the root platform wall;
the tip (18) having a tip platform (22) presenting a surface (24) on a side toward the airfoil, which surface is referred to as a tip platform wall; and
the airfoil (16) having an outer surface referred to as the airfoil surface (30) and comprising a pressure side (30ps) and a suction side (30ss);
the blade being **characterized in that** each of said platform walls is constituted by a pressure side portion (15ps, 24ps) on the pressure side and a suction side portion (15ss, 24ss) on the suction side, which portions meet at a crest curve (45, 65) going from an upstream edge (15U, 24U) to a downstream edge (15D, 24D) of the platform wall passing through the airfoil, in such a manner that each of said platform walls has a slope discontinuity between the two sides of the crest curve; and **in that**
every point of a first surface selected from the pressure side surface and the suction side surface, and every point of said root and tip platform wall portions situated on the same side as the first surface presents a normal forming an acute angle or a right angle relative to a direction referred to as a first fabrication direction (Aps).

2. A blade according to claim 1, wherein every point of the second surface of the airfoil, other than the first surface, and every point of said root and tip platform wall portions situated on the same side as the second surface presents a normal forming an acute angle or a right angle relative to a direction referred to as a second fabrication direction.

3. A blade according to claim 2, wherein, in radial view, the first and second fabrication directions are parallel and opposite.

4. A blade according to any one of claims 1 to 3, wherein, over a portion of the axial extent of the blade, or indeed on all of the axial extent of the blade, a section of the root platform wall or of the tip platform wall on the first side in a plane containing the first fabrication direction and a direction substantially radial for the blade is constituted mainly by a straight line segment.

5. A blade according to any one of claims 1 to 4, for a turbomachine bladed wheel (100) having N blades, and wherein an edge defining the platform wall of a first platform of the blade on the pressure side coincides substantially with an edge defining the platform wall of the first platform of the suction side, after a rotation through 360°/N.

6. A bladed wheel (100) comprising a plurality of blades (10) according to any one of claims 1 to 5.

7. A turbomachine (110) including a bladed wheel (100) according to claim 6, in particular for a low pressure turbine.

8. A modeling method for modeling a blade comprising in succession a root, an airfoil, and a tip, an outside surface of the blade being constituted by a suction side and by a pressure side, the root (14) having a root platform (13) presenting a surface (15) on a side toward the airfoil, which surface is referred to as the root platform wall; the tip (18) having a tip platform (22) presenting a surface (24) on a side toward the airfoil, which surface is referred to as a tip platform wall; and the airfoil (16) having an outer surface referred to as the airfoil surface (30) and comprising a pressure side (30ps) and a suction side (30ss);
the method being **characterized in that** it comprises the following steps:
a) creating a CAD model of a first surface selected from the pressure side and the suction side in such a manner that every point of the first surface presents a normal forming an acute angle or a right angle relative to a direction referred to as the first fabrication direction; and
b) creating a CAD model of root and tip platform walls of the blade in such a manner that each of said platform walls is constituted by a pressure side portion (15ps, 24ps) on the pressure side and a suction side portion (15ss, 24ss) on the suction side, which portions meet at a crest curve (45, 65) going from an upstream edge (15u, 24u) to a downstream edge (15d, 24d) of the platform wall passing through the airfoil, each of said platform walls having a slope discontinuity between the two sides of the crest curve; and that every point on the first surface and every point of said root and tip platform wall portions situated on the same side as the first surface presents a normal forming an acute angle or a right angle relative to the first fabrication direction.

9. A modeling method according to claim 8, wherein in step b), a CAD model of one of said platform walls is created from the crest curve (45c), which is obtained by shifting or moving in translation a construction curve (45) .

10. A modeling method according to claim 9, wherein in step b), the construction curve is created in such a manner that it crosses right through a theoretical airfoil surface (30).

11. A modeling method according to any one of claims 8 to 10, wherein, in step b), one of said platform walls is created in such a manner that a limitation curve defining said platform wall on the pressure side coincides substantially with a limitation curve defining said platform wall on the suction side, ignoring a rotation of 360°/N.

12. A modeling method according to any one of claims 8 to 11, wherein, in step b), the CAD model of at least one of said portions of one of said platform walls is obtained by sweeping a straight line segment that moves while bearing against two curves (45c, 52ps, 52ss).

13. A modeling method for modeling a blade in which a first side of a blade is modeled using the method according to any one of claims 8 to 12, the method further comprising the following step:
c) creating a CAD model of a second surface selected from among the pressure side and the suction side, other than the first surface, in such a manner that every point of the second surface presents a normal forming an acute angle or a right angle relative to a direction referred to as the second fabrication direction; and wherein, in step b), the CAD model of the root and tip platform walls is created in such a manner that every point of the root and tip platform walls on the same side as the second surface presents a normal forming an acute angle or a right angle relative to the second fabrication direction.

14. A modeling method according to claim 13, wherein the first and second fabrication directions are identical.

15. A method of fabricating a blade for a turbomachine bladed wheel, the blade comprising a root, a tip, and an airfoil, the method being **characterized in that** in order to define the blade, use is made of a modeling method according to any one of claims 8 to 14.
